# EUROPÄISCHE PATENTANMELDUNG

(11) **EP 4 697 033 A1**
(43) Veröffentlichungstag der Anmeldung: **18.02.2026**
(21) Anmeldenummer: 25194422.9
(22) Anmeldetag: 06.08.2025
(51) Int. Cl.: G01R 19/165, H02H 7/09, H02P 3/12, H02P 3/22, B25J 19/00, B25J 9/12, B25J 15/02

(54) **ENDEFFEKTOR MIT INTEGRIERTER RÜCKSPEISESCHUTZEINRICHTUNG, VERFAHREN**

(30) Priorität: 13.08.2024 DE 102024123031
(71) Anmelder: SCHUNK SE & Co. KG Spanntechnik Greiftechnik Automatisierungstechnik, 74348 Lauffen am Neckar (DE)
(72) Erfinder: Pirner, Thilo, 71720 Oberstenfeld (DE); Wöhr, Johannes, 74363 Güglingen (DE); Stalter, Thomas, 75438 Knittlingen (DE); Mittendorff, Steffen, 74074 Heilbronn (DE)
(74) Vertreter: DREISS Patentanwälte PartG mbB

(57) **Zusammenfassung**

Die Erfindung betrifft einen Endeffektor zur Anordnung an einer Handhabungsvorrichtung, der Endeffektor umfassend wenigstens ein mittels eines elektrischen Antriebs bewegliches Effektorelement, eine im Endeffektor integrierte Rückspeiseschutzeinrichtung zur Aufnahme und/oder Umwandlung einer Rückspeisespannung beim Bremsvorgang des elektrischen Antriebs, und eine Steuerungseinrichtung zur Steuerung der Rückspeiseschutzeinrichtung.

## Beschreibung

Die Erfindung betrifft einen Endeffektor und ein Verfahren zum Betreiben eines Endeffektors.

Bei Endeffektoren mit elektrischen Antrieben wirkt bei Bremsvorgängen der Antrieb als Generator, wobei der Rotor eine elektrische Spannung in den Statorwicklungen induziert. Die induzierte Spannung kann in einem Endeffektor zur Störung oder Zerstörung von Leistungs- und Steuerungselektronik führen. Auch externe Energiequellen, wie Netzteile, welche den Endeffektor mit Energie versorgen, können bei einer höheren Rückspeisespannung in einen Fehlermodus wechseln und abschalten. Dies führt zu Problemen im Prozess und kann zudem ein Sicherheitsrisiko darstellen.

Aus der DE 10 2016 109 295 A1 ist ein Hubwerk mit einem Bremschopper bekannt. Aus der DE 10 2013 014 609 B4 ist eine Motorsteuervorrichtung mit zwei Widerstandsentladungseinheiten bekannt.

Der Erfindung liegt folglich die Aufgabe zugrunde, einen zuverlässigen Betrieb eines Endeffektors im Zusammenspiel mit unterschiedlichen Energiequellen, insbesondere Netzteilen, sicherzustellen.

Die der Erfindung zugrundeliegende Aufgabe wird durch einen Endeffektor zur Anordnung an einer Handhabungsvorrichtung mit den Merkmalen des Anspruchs 1 gelöst. Der Endeffektor weist ein Grundgehäuse; wenigstens ein bewegliches, insbesondere im oder am Grundgehäuse beweglich gelagertes, Effektorelement; einen, insbesondere im oder am Grundgehäuse angeordneten, elektrischen Antrieb zum Antreiben des wenigstens einen Effektorelements; eine im Endeffektor integrierte, insbesondere im Grundgehäuse angeordnete, Rückspeiseschutzeinrichtung zur Aufnahme und/oder Umwandlung einer Rückspeisespannung beim Bremsvorgang des elektrischen Antriebs; sowie eine, insbesondere im oder am Grundgehäuse angeordnete, Steuerungseinrichtung zur Steuerung der Rückspeiseschutzeinrichtung.

Demnach kann die durch den Bremsvorgang im elektrischen Antrieb gespeicherte Energie in die Rückspeisespannung aufgenommen werden und vorzugsweise in Wärme umgewandelt werden. Folglich können die Leistungs- und Steuerungselektronik des Endeffektors sowie integrierte oder externe Energiequellen vor zu hoher Ströme oder Spannungen, insbesondere der Rückspeisespannung, geschützt werden. Eine separate Sicherung an einem kundenseitigen Netzteil kann dadurch entfallen.

In einer Ausführungsform ist ein Greifer zur Anordnung an einer Handhabungsvorrichtung bereitgestellt, wobei der Greifer umfasst: ein Grundgehäuse; wenigstens ein im oder am Grundgehäuse beweglich gelagertes, mittels eines elektrischen Antriebs bewegliches Effektorelement, insbesondere Greifbacke; eine im Grundgehäuse angeordnete Rückspeiseschutzeinrichtung zur Aufnahme und/oder Umwandlung einer Rückspeisespannung beim Bremsvorgang des elektrischen Antriebs; und eine Steuerungseinrichtung zur Steuerung der Rückspeiseschutzeinrichtung, welche dazu gerichtet ist, die Rückspeiseschutzeinrichtung in Abhängigkeit eines Mittelwerts einer Ist-Spannung und einer Aktivierungs-Grenzspannung und/oder Deaktivierungs-Grenzspannung zu steuern, wobei sich die Aktivierungs-Grenzspannung und/oder die Deaktivierungs-Grenzspannung aus der Ist-Spannung und einem Aktivierungs-Offset und/oder einem Deaktivierungs-Offset bestimmt.

Der Endeffektor kann vorzugsweise als, insbesondere mechatronischer, Greifer ausgebildet sein. Es ist vorteilhaft, wenn der Greifer ein Grundgehäuse, wenigstens zwei im Grundgehäuse geführte und verlagerbare Greifbacken aufweist. Die Greifbacken sind vorzugsweise zwischen einer Öffnungsstellung und einer Schließstellung verlagerbar. Der Greifer weist eine Greifaufnahme zum Aufnehmen eines Objekts auf, wobei die Greifaufnahme durch das Grundgehäuse und/oder die Greifbacken begrenzt wird. Das Grundgehäuse weist zum Führen der Greifbacken vorzugsweise eine Führungsausnehmung auf. Der Greifer kann zwei entlang einer Achse verlagerbare Greifbacken aufweisen. Alternativ kann der Greifer drei oder mehrere Greifbacken aufweisen (Zentrischgreifer). Es ist denkbar, dass der Greifer als Innen- oder Außengreifer ausgebildet ist.

Der Endeffektor ist aufgrund der beschränkten Baugröße des Endeffektors, insbesondere Grundgehäuses, vorzugsweise akkumulatorfrei, also ohne Akkumulator, ausgebildet. Eine Speicherung der Bremsenergie ist daher im Sinne eines kompakten Endeffektors nicht sinnvoll bzw. möglich.

Der elektrische Antrieb ist vorzugsweise als elektrischer Motor, insbesondere Innenläufermotor oder Außenläufermotor, ausgebildet.

Es ist vorteilhaft, wenn die Rückspeiseschutzeinrichtung wenigstens einen Lastwiderstand, insbesondere zwei, drei oder vier Lastwiderstände, zum Umwandeln der Rückspeisespannung in Wärme aufweist. Die Bremsenergie wird im wenigstens einen Lastwiderstand in Wärmeenergie umgewandelt. Die Wärmeenergie wird vorzugsweise über das Grundgehäuse an die Umgebung abgegeben.

Es ist ferner vorteilhaft, wenn die Rückspeiseschutzeinrichtung einen Schalter zum Aktivieren und Deaktivieren der Rückspeiseschutzeinrichtung aufweist. Der Schalter ist vorzugsweise als Feldeffekttransistor ausgebildet. Im Deaktivierungszustand wird keine Energie zum Antreiben des Endeffektors in Wärmeenergie umgewandelt. Im Aktivierungszustand wird unter anderem die durch den Bremsvorgang in das eingeleitete Bremsenergie in Wärmeenergie umgewandelt. Demnach kann die Rückspeiseschutzeinrichtung gezielt zum Einsatz kommen, wenn z.B. eine Rückspeisespannung im Endeffektor eingekoppelt wird. Im Deaktivierungszustand kann die Energiequelle, insbesondere das Netzteil, kann die geeignete Spannung selbstständig im Endeffektor regeln.

Der Endeffektor weist vorzugsweise eine elektrische Schnittstelle zum Anschluss an eine elektrische Energiequelle zur Energieversorgung des elektrischen Antriebs auf. Die elektrische Energiequelle kann z.B. ein externes Netzteil sein.

Der Endeffektor weist vorzugsweise eine Versorgungsleitung auf, welche die elektrische Schnittstelle mit dem elektrischen Antrieb elektrisch verbindet.

Eine vorteilhafte Weiterbildung sieht vor, dass die Rückspeiseschutzeinrichtung an einer die elektrische Schnittstelle und den elektrischen Antrieb elektrisch verbindende Versorgungsleitung anschließt. Es ist vorteilhaft, wenn der wenigstens eine Lastwiderstand elektrisch parallel zur Versorgungsleitung angeschlossen ist.

Die Versorgungsleitung kann insbesondere separat zu einer ersten Platine und/oder einer zweiten Platine ausgebildet sein. Alternativ kann die Versorgungsleitung auch auf und/oder an und/oder in einer ersten Platine und/oder einer zweiten Platine angeordnet sein. Es ist vorteilhaft, wenn das Netzteil im Greifer und/oder auf der ersten Platine und/oder der zweiten Platine angeordnet ist.

Es ist vorteilhaft, wenn die Rückspeiseschutzeinrichtung derart ausgebildet ist, dass der Schalter in einem Aktivierungszustand den wenigstens einen Lastwiderstand elektrisch mit der Versorgungsleitung verbindet und/oder in einem Deaktivierungszustand den wenigstens einen Lastwiderstand elektrisch von der Versorgungsleitung trennt. Demnach fließt ein Strom von der Versorgungsleitung nur dann zur Rückspeiseschutzeinrichtung, wenn der Schalter im Aktivierungszustand ist.

Vorzugsweise weist der Endeffektor eine Spannungsmesseinrichtung zum Erfassen einer ersten Größe auf, die eine an der Versorgungsleitung anliegenden Ist-Spannung charakterisiert, insbesondere die Ist-Spannung selbst. Die Spannungsmesseinrichtung kann zyklisch in diskreten Zeitintervallen oder kontinuierlich die erste Größe messen.

Es ist ferner vorteilhaft, wenn die Rückspeiseschutzeinrichtung, insbesondere der wenigstens eine Lastwiderstand und/oder der Schalter und/oder eine Kontaktstelle zur Verbindung des Lastwiderstands mit der Versorgungsleitung, auf einer gemeinsamen ersten Platine angeordnet ist.

Eine vorteilhafte Weiterbildung sieht vor, dass die Steuerungseinrichtung zur Steuerung des elektrischen Antriebs und zum Aktivieren und Deaktivieren der Rückspeiseschutzeinrichtung eingerichtet ist. Die Steuerungseinrichtung kann einen Microcontroller mit einer Firmware umfassen. Der Microcontroller kann, insbesondere als auf der zweiten Platine, integrierter Schaltkreis ausgebildet sein. Demnach kann die Steuerungseinrichtung die Rückspeiseschutzeinrichtung gezielt in Abhängigkeit der zuvor beschriebenen Bedingungen aktivieren und deaktivieren.

Die Steuerungseinrichtung ist vorzugsweise auf einer zur ersten Platine separat ausgebildeten zweiten Platine angeordnet. Auf der ersten Platine kommt es zu einer erheblichen Wärmeentwicklung und/oder zu elektromagnetischen Störungen durch hohe Ströme, welche die Komponenten auf der zweiten Platine negativ beeinflussen können. Durch die separate Ausbildung der Platinen kann dieses Phänomen reduziert werden. Es ist denkbar, dass die erste Platine und die zweite Platine beabstandet zueinander ausgebildet sind. Es ist alternativ denkbar, dass die erste Platine und die zweite Platine durch eine gemeinsame Platine gebildet sind und/oder durch eine gemeinsame Platine erfüllt werden. In dem Fall kann die Rückspeiseschutzeinrichtung, insbesondere der wenigstens eine Lastwiderstand und/oder der Schalter zusammen mit der Steuerungseinrichtung, insbesondere mit dem Microcontroller und/oder Komponenten einer Leistungselektronik, auf einer gemeinsamen Platine angeordnet sein.

Es ist vorteilhaft, wenn die Steuerungseinrichtung derart eingerichtet ist, dass diese die Rückspeiseschutzeinrichtung in Abhängigkeit einer an der Versorgungsleitung anliegenden Ist-Spannung und/oder eines Betriebszustands des Endeffektors, insbesondere eines motorischen Betriebszustands und eines generatorischen Betriebszustands, aktiviert oder deaktiviert. Demnach kann die Rückspeiseschutzeinrichtung durch die Steuerungseinrichtung gezielt aktiviert und deaktiviert werden.

Es ist ferner vorteilhaft, wenn die Steuerungseinrichtung derart eingerichtet ist, dass diese die Rückspeiseschutzeinrichtung aktiviert, wenn eine an der Versorgungsleitung anliegende Ist-Spannung eine Aktivierungs-Grenzspannung übersteigt und insbesondere wenn sich der Endeffektor, vorzugsweise überwiegend, in einem generatorischen Betriebszustand befindet. Demnach können Betriebsbereiche im Endeffektor hinterlegt sein, in welchen die elektrischen Komponenten keinen Schaden nehmen.

Es ist zudem vorteilhaft, wenn die Steuerungseinrichtung derart eingerichtet ist, dass diese die Rückspeiseschutzeinrichtung deaktiviert, wenn eine an der Versorgungsleitung anliegende Ist-Spannung eine Deaktivierungs-Grenzspannung unterschreitet. Demnach wird die Rückspeiseschutzeinrichtung ausgeschaltet, sodass es nicht zu einem Konflikt mit einem Netzteil kommt, welcher ebenfalls die Spannung regelt. Es ist ferner vorteilhaft, wenn die Steuerungseinrichtung derart eingerichtet ist, dass diese die Rückspeiseschutzeinrichtung deaktiviert, wenn zusätzlich oder alternativ sich der Endeffektor, vorzugsweise überwiegend, in einem motorischen Betriebszustand befindet. Demnach wird die Rückspeiseschutzeinrichtung deaktiviert, wenn es zu keinen Rückspeisespannungen mehr kommt.

Im Sinne der Erfindung ist unter einem "motorischen Betriebszustand" zu verstehen, dass der elektrische Antrieb zum Antreiben des wenigstens einen Effektorelements Verwendung findet. In dem Zustand wird der elektrische Antrieb mittels einer Energiequelle, insbesondere ein Netzteil, mit einer elektrischen Energie versorgt, wobei die Energie von der Energiequelle zum elektrischen Antrieb geleitet wird. Im Sinne der Erfindung ist unter einem "generatorischen Betriebszustand" zu verstehen, dass während eines Bremsvorgangs eine kinetische Energie in elektrische Energie mittels des elektrischen Antriebs umgewandelt wird, die dann in Richtung der Energiequelle zurückgespeist wird.

Vorzugsweise weist die Rückspeiseschutzeinrichtung eine temperaturabhängige Schutzschaltung auf. Die Schutzschaltung ist vorzugsweise derart ausgebildet, dass diese in einen Unterbrechungszustand wechselt, wenn eine Grenztemperatur erreicht oder überstiegen wird. Dies kann zum einen mechanisch erfolgen, indem die Schutzschaltung in Form einer Schmelzsicherung durchbrennt und/oder softwareseitig erfolgen, indem die Schutzschaltung unterbrochen wird, sodass keine Energie zum Lastwiderstand geleitet wird.

Die der Erfindung zugrundeliegende Aufgabe wird ebenfalls durch ein Verfahren zum Betreiben eines Endeffektors mit den Merkmalen des Anspruchs 13 gelöst. Das Verfahren umfasst die folgenden Schritte:
a) Erfassen einer an einer Versorgungsleitung des Endeffektors anliegenden Ist-Spannung,
b) wenn die Ist-Spannung eine Aktivierungs-Grenzspannung überschreitet, Aktivieren einer im Endeffektor integrierten Rückspeiseschutzeinrichtung, und/oder
c) wenn die Ist-Spannung eine Deaktivierungs-Grenzspannung unterschreitet, Deaktivieren der im Endeffektor integrierten Rückspeiseschutzeinrichtung.

Die Aktivierungs-Grenzspannung stellt sicher, dass die Rückspeiseschutzeinrichtung nur dann eingreift, wenn tatsächlich eine zu hohe Spannung im System vorliegt.

Es ist denkbar, dass das Verfahren als computerimplementiertes Verfahren ausgebildet ist.

Vorzugsweise umfasst das Verfahren vor Schritt b) den folgenden Schritt:
a1) Erfassen eines Betriebszustands des Endeffektors, insbesondere eines generatorischen Betriebszustands oder eines motorischen Betriebszustands.

Es ist vorteilhaft, wenn die Rückspeiseschutzeinrichtung gemäß Schritt b) nur dann aktiviert wird, wenn die Ist-Spannung die Aktivierungs-Grenzspannung überschreitet und zudem, wenn sich der Endeffektor in einem generatorischen Betriebszustand befindet.

Im generatorischen Betrieb wirkt der elektrische Antrieb als Generator, wenn er von Last getrieben wird und elektrische Energie zurück ins System speist. Eine im Endeffektor, insbesondere in der Steuereinheit, vorgesehene Reglerkaskade erkennt, ob der elektrische Antrieb als Antrieb oder als Generator verwendet wird. Im Sinne der Erfindung ist unter einer "Reglerkaskade" eine Anordnung von mehreren Regelkreisen zu verstehen, die hintereinandergeschaltet sind. Jeder Regelkreis in der Reglerkaskade hat seine eigene Regelgröße und seinen eigenen Regler.

Es ist ferner vorteilhaft, wenn die Rückspeiseschutzeinrichtung gemäß Schritt c) nur dann deaktiviert wird, wenn die Ist-Spannung eine Deaktivierungs-Grenzspannung unterschreitet, und/oder, wenn sich der Endeffektor in einem motorischen Betriebszustand befindet.

Eine vorteilhafte Weiterentwicklung des Verfahrens sieht vor, dass die erfasste Ist-Spannung zum Bestimmen eines Mittelwerts der Ist-Spannung, insbesondere mittels eines Infinite Impulse Response (IIR) Filter, gefiltert wird. Da ein IIR-Filter sowohl aktuelle als auch vergangene Werte berücksichtigt, kommt es zu einer effektiven Filterung von Störsignalen. Die Verwendung eines IIR-Filters ermöglicht eine starke Filterung, um hochfrequente Rauschanteile zu eliminieren und einen glatten, stabilisierten Mittelwert der Ist-Spannung zu erhalten.

Es ist vorteilhaft, wenn die Aktivierungs-Grenzspannung mittels Addierens eines Aktivierungs-Offsets zum Mittelwert bestimmt wird. Es ist ferner vorteilhaft, wenn die Deaktivierungs-Grenzspannung mittels Addierens eines Deaktivierungs-Offsets zum Mittelwert bestimmt wird. In dem Fall handelt es sich um relative Deaktivierungsschwellen bzw. Aktivierungsschwellen. Dies ermöglicht eine bessere Anpassung an variable Betriebsbedingungen, da sie in Beziehung zu den aktuellen Zuständen des Systems stehen. Relative Aktivierungsschwellen sind unabhängig von absoluten Werten. Dies bedeutet, dass Änderungen in der Versorgungsspannung oder anderen globalen Systemparametern die Schwellen nicht direkt beeinflussen. In Systemen mit verschiedenen Konfigurationen oder Anpassungen kann die Verwendung einer relativen Aktivierungsschwelle flexibler sein. Die Schwelle kann sich an unterschiedliche Betriebszustände oder -varianten anpassen, ohne dass spezifische absolute Spannungsgrenzen festgelegt werden müssen.

Der Endeffektor, insbesondere die Steuerungseinrichtung und deren Firmware, ist parametrierbar. Als Parameter können beispielsweise die Aktivierungs- und Deaktivierungs-Offsets übergeben werden. Durch die Parametrierbarkeit der Offsets kann die Empfindlichkeit der Aktivierungsschwelle und Deaktivierungsschwelle an die spezifischen Anforderungen des Systems oder der Anwendung angepasst werden. Damit geht eine hohe Flexibilität in der Anpassung an unterschiedliche Betriebsbedingungen einher.

Alternativ können aber auch absolute Aktivierungs- und Deaktivierungs-Grenzspannungen im Endeffektor hinterlegt sein.

Der Aktivierungs-Offset ist vorzugsweise betragsmäßig größer als der Deaktivierungs-Offset. Die Aktivierungs-Grenzspannung ist vorzugsweise betragsmäßig größer als die Deaktivierungs-Grenzspannung.

Nachfolgend ist ein Beispiel für variable Betriebsbedingungen einer Rückspeiseschutzeinrichtung bzw. eines Bremschoppers dargestellt:

| | |
|---|---|
| Mittelwert der Ist-Spannung | 25,1 V |
| Aktivierungs-Offset | 2,0 V |
| Aktivierungs-Grenzspannung | 27,1 V |
| Deaktivierungs-Offset | 1,0 V |
| Deaktivierungs-Grenzspannung | 26,1 V |

Es ist zudem vorteilhaft, wenn ein Fehler ausgelöst und/oder eine Fehlermeldung ausgegeben wird, wenn trotz aktivierter Rückspeiseschutzeinrichtung nach einer maximalen Aktivzeit die Ist-Spannung nicht die Deaktivierungs-Grenzspannung unterschreitet. In dem Fall kann davon ausgegangen werden, dass die Rückspeiseschutzeinrichtung einen Defekt hat, wie z.B. die Schutzschaltung ist in den Unterbrechungszustand gewechselt. Die Aktivzeit beginnt beim Aktivieren, also beim Überschreiten der Aktivierungs-Grenzspannung, der Rückspeiseschutzeinrichtung und endet beim Deaktivieren, also beim Unterschreiten der Deaktivierungs-Grenzspannung, der Rückspeiseschutzeinrichtung.

Die der Erfindung zugrundeliegende Aufgabe wird ebenfalls durch ein Computerprogramm mit den Merkmalen des Anspruchs 21 gelöst. Das Computerprogramm umfasst Befehle, die bei der Ausführung des Computerprogramms durch einen Computer diesen veranlassen, das zuvor beschriebene Verfahren auszuführen. Vorzugsweise weist das Computerprogramm eine auf einem Microcontroller ausführbare Firmware auf.

Weitere Einzelheiten und vorteilhafte Ausgestaltungen der Erfindung sind der nachfolgenden Beschreibung zu entnehmen, anhand derer Ausführungsbeispiele der Erfindung weiter beschrieben und erläutert sind.

Es zeigen:
- Fig. 1: ein Blockschaltbild eines an eine Energiequelle angeschlossenen Endeffektors;
- Fig. 2: ein Blockschaltbild einer Rückspeiseschutzeinrichtung;
- Fig. 3: Diagramm eines Spannungsverlaufs einer Ist-Spannung, des Mittelwerts und der Grenzspannungen.

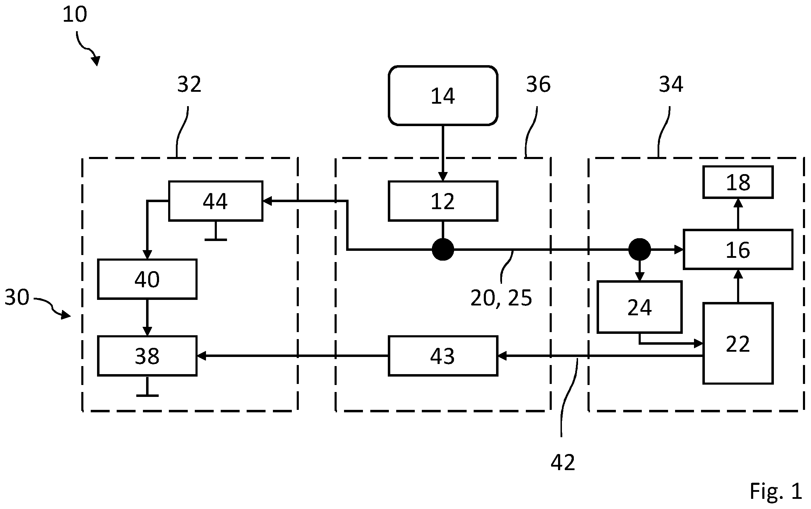

In Fig. 1 ist ein Endeffektor 10, insbesondere ein Greifer, in einem Blockschaltbild dargestellt. Der Endeffektor 10 weist ein nicht dargestelltes Grundgehäuse auf. Im Grundgehäuse weist der Endeffektor eine elektrische Schnittstelle 12 zur Verbindung mit einer externen Energiequelle 14 auf. Ferner weist der Endeffektor 10 einen im Grundgehäuse angeordneten elektrischen Antrieb 16 zum Antreiben von wenigstens einem Effektorelement 18 auf. Der elektrische Antrieb 16 ist mit der elektrischen Schnittstelle 12 mittels einer Versorgungsleitung 20 elektrisch verbunden.

Mittels der Energiequelle 14 wird der elektrische Antrieb 16 über die elektrische Schnittstelle 12 und die Versorgungsleitung 20 mit Energie, insbesondere einer Motorspannung, vorzugsweise in Höhe von 24V, versorgt. Der Endeffektor 10 weist eine Steuerungseinrichtung 22 zur Steuerung des elektrischen Antriebs 16 auf. Die Steuerungseinrichtung 22 weist vorzugsweise eine Firmware auf.

Der elektrische Antrieb 16 kann z.B. als Außenläufermotor ausgebildet sein. Bei einem Bremsvorgang des Endeffektors, insbesondere des Effektorelements, wirkt der Motor nicht als Antrieb, sondern als Generator. Dabei wird mittels des Rotors in den Statorwicklungen eine Rückspeisespannung induziert, welche schädlich für die Leistungs- und Steuerungs-Elektronik sowie die externe Energiequelle 14 sein kann und zu Ausfällen führen kann.

An der Versorgungsleitung 20 ist eine Spannungsmesseinrichtung 24 zum Erfassen einer Ist-Spannung 25 vorgesehen.

Die Rückspeisespannung kann sich mittels der Versorgungsleitung 20 auf die externe Energiequelle 14 auswirken. Daher weist der Endeffektor 10 eine Rückspeiseschutzeinrichtung 30 auf. Der Einsatz einer Rückspeiseschutzeinrichtung 30 verhindert eine Überhöhung der Versorgungsspannung, indem sie sicherstellt, dass die Bremsenergie kontrolliert abgeführt wird. Dies schützt die elektronischen Komponenten und das Kundennetzteil vor Schäden durch zu hohe Spannungen oder Ströme. Bei einer Überhöhung der Versorgungsspannung übersteigt die anliegende Spannung festgelegte Betriebsgrößen angeschlossenen elektronischen Komponenten, insbesondere des Netzteils, was zu einem Schaden an den angeschlossenen elektronischen Komponenten, insbesondere dem Netzteil, führen kann. Ohne Rückspeiseschutzeinrichtung 30 ist der Endeffektor nicht mehr zuverlässig betreibbar. Der Effekt der Überhöhung der Versorgungsspannung potenziert sich beim Betrieb mehrerer Endeffektoren an einem Netzteil.

Die Rückspeiseschutzeinrichtung 30 ist auf einer ersten Platine 32, insbesondere Bremschopper-Platine, angeordnet. Die erste Platine 32 ist vorzugsweise separat zu einer zweiten Platine 34, insbesondere Hauptplatine, ausgebildet. Auf der zweiten Platine 34 sind vorzugsweise die Steuerungseinrichtung 22 und/oder die Spannungsmesseinrichtung 24 angeordnet. Ferner kann eine separate dritte Platine 36, insbesondere Anschlussplatine, vorgesehen sein, auf welcher die elektrische Schnittstelle 12 vorgesehen ist.

Die Rückspeiseschutzeinrichtung 30 weist einen Schalter 38 und wenigstens einen Lastwiderstande 40 zum Umwandeln von elektrischer Energie in Wärmeenergie auf. Der Schalter 38 ist als Feldeffekttransistor ausgebildet. Der Schalter 38 ist zwischen einem Aktivierungszustand und einem Deaktivierungszustand mittels der Steuerungseinrichtung 32 schaltbar.

Die Rückspeiseschutzeinrichtung 30 schließt an die Versorgungsleitung 20 an, wobei die Lastwiderstände 40 elektrisch parallel zur Versorgungsleitung 20 bzw. dem elektrischen Antrieb 16 geschaltet ist.

Im Deaktivierungszustand ist der Schalter 38 geöffnet, sodass kein Strom über die Lastwiderstände 40 fließt. Dies entspricht dem Betrieb des Motors als Antrieb. Bei einem starken Bremsvorgang steigt die Ist-Spannung 25 in der Versorgungsleitung 20 an. Die Steuerungseinrichtung 22 erfasst den generatorischen Betrieb des elektrischen Antriebs 16 sowie den Anstieg der Ist-Spannung 25 und schließt den Schalter 28. Im Aktivierungszustand fließt Strom zu den Lastwiderständen 40, sodass die durch den Bremsvorgang in den Endeffektor eingeleitete Bremsenergie in Wärmeenergie umgewandelt wird. Dazu ist die Steuerungseinrichtung 22 mittels einer Schaltleitung 42 mit dem Schalter 38 verbunden. Die Schaltleitung 42 ist vorzugsweise derart ausgebildet, dass die Steuerungseinrichtung 22 und der Schalter 38 galvanisch getrennt sind. Zur galvanischen Trennung ist insbesondere ein Mittel 43 vorgesehen, welches vorzugsweise auf der dritten Platine 36 angeordnet sein kann.

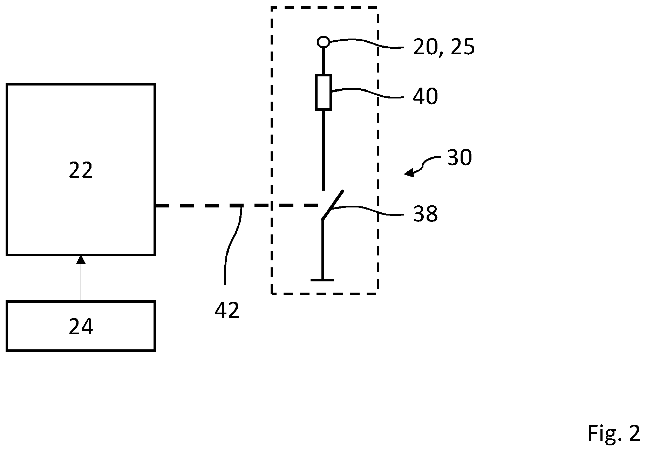

Die Steuerungseinrichtung 22, insbesondere die Firmware, erhält gemäß Fig. 2 das Spannungssignal der Spannungsmesseinrichtung 24 über die an der Versorgungsleitung 20 anliegende Ist-Spannung 25. Anschließend bestimmt die Steuerungseinrichtung 22 in Abhängigkeit der Ist-Spannung 25, ob die Rückspeiseschutzeinrichtung 30 aktiviert oder deaktiviert werden soll. Je nachdem, welche Bedingungen vorliegen, sendet die Steuerungseinrichtung 22 mittels der Schaltleitung 42 ein Schaltsignal und öffnet (Deaktivierungszustand) oder schließt (Aktivierungszustand) damit den Schalter 38.

Im Aktivierungszustand fließt ein Strom über die Lastwiderstände 40, wobei die elektrische Energie in Wärmeenergie umgewandelt wird. Daher kann es an der ersten Platine 32 zu einer erheblichen Temperatursteigerung kommen. Damit nicht beliebig viel elektrische Energie in Wärmeenergie an den Lastwiderständen umgewandelt wird, ist eine vorgeschaltete temperaturabhängige Schutzschaltung 44 (Übertemperaturabschaltung) vorgesehen. Die Schutzschaltung 44 ist vorzugsweise derart ausgebildet, dass diese die elektrische Verbindung zwischen der Versorgungsleitung 20 und den Lastwiderständen 40 unterbricht, wenn eine Grenztemperatur erreicht ist. Alternativ oder zusätzlich kann die Schutzschaltung 44 auch spannungs- und/oder stromabhängig ausgebildet sein und die elektrische Verbindung bei Erreichen einer Grenzspannung und/oder eines Grenzstroms unterbrechen.

Die Steuerungseinrichtung 22 ist vorzugsweise derart ausgebildet, dass zunächst eine an der Versorgungsleitung 20 anliegende Ist-Spannung 25 erfasst wird. Ferner bestimmt die Steuerungseinrichtung 22, ob sich der Endeffektors 10 im motorischen Betriebszustand oder im generatorischen Betriebszustand befindet. Ferner bestimmt die Steuerungseinrichtung 22 einen Mittelwert 46 der Ist-Spannung 25, indem die Ist-Spannung 25 mittels eines IIR-Filters gefiltert wird.

Zudem bestimmt die Steuerungseinrichtung 22 eine Aktivierungs-Grenzspannung 48 und eine Deaktivierungs-Grenzspannung 50. Die Aktivierungs-Grenzspannung 48 stellt ein zulässiges Spannungsniveau des Endeffektors 10 dar. Die Grenzspannungen 48, 50 werden bestimmt, indem jeweils ein Aktivierungs-Offset 52 und ein Deaktivierungs-Offset 54 auf den Mittelwert 46 aufaddiert wird. Der Deaktivierungs-Offset 54 ist so gewählt, dass die Rückspeiseschutzeinrichtung 30 nicht mit der Spannungsregelung eines Netzteils konkurriert. Der Aktivierungs-Offset 52 kann z.B. 2V und der Deaktivierungs-Offset 54 kann 1V betragen. Bei einem Mittelwert 46 von 24V kommt es zu einer Aktivierungs-Grenzspannung 48 von 26V und einer Deaktivierungs-Grenzspannung 50 von 25V.

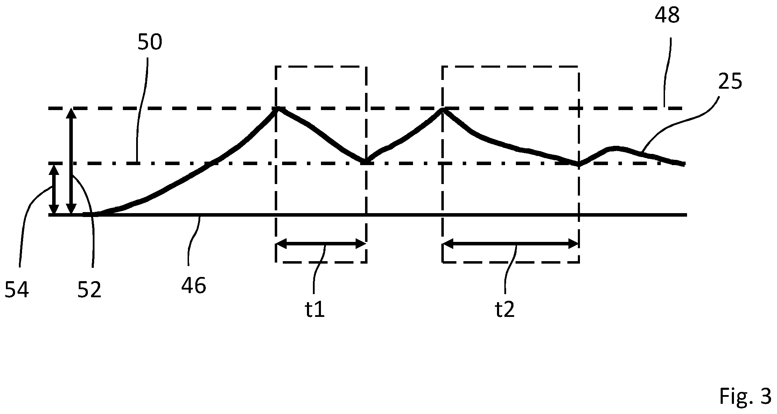

Wenn gemäß Fig. 3 die Ist-Spannung 25 die Aktivierungs-Grenzspannung 48 überschreitet und der Endeffektor sich im generatorischen Betriebszustand befindet, sendet die Steuerungseinrichtung 22 mittels der Schaltleitung 42 ein Schaltsignal an den Schalter 38, welcher daraufhin schließt und die Rückspeiseschutzeinrichtung 30 aktiviert. Folglich wird die Bremsenergie mittels der Lastwiderstände 40 in Wärmeenergie umgewandelt. Die Aktivierung des Rückspeiseschutzeinrichtung 30 ist in Fig. 3 mittels der gestrichelten Bereiche dargestellt. Demnach zeigt Fig. 3 eine erste Aktivierungsphase mit einer ersten Aktvierungszeit t1 und eine zweite Aktivierungsphase mit einer zweiten Aktivierungszeit t2.

Wenn gemäß Fig. 3 die Ist-Spannung 25 die Deaktivierungs-Grenzspannung 50 unterschreitet und/oder der Endeffektor sich im motorischen Betriebszustand befindet, sendet die Steuerungseinrichtung 22 mittels der Schaltleitung 42 wieder ein Schaltsignal an den Schalter 38, welcher daraufhin öffnet und die Rückspeiseschutzeinrichtung 30 deaktiviert.

So kann es während eines Bremsvorgangs dazu führen, dass die Rückspeiseschutzeinrichtung 30 mehrfach aktiviert und deaktiviert wird. Dabei wird die überschüssige elektrische Energie in Form von Pulsen über die Lastwiderstände 40 abgeleitet. Die Rückspeiseschutzeinrichtung 30 wird vorzugsweise periodisch geschaltet, sodass die überschüssige Bremsenergie periodisch durch die Lastwiderstände 40 in Wärmeenergie umgewandelt wird.

Ferner erfasst die Steuerungseinrichtung 22 die Aktivzeit der Rückspeiseschutzeinrichtung 30. Sollte die Ist-Spannung nach einer maximalen Aktivzeit von 1s, insbesondere 500ms, vorzugsweise 300ms, nicht die Deaktivierungs-Grenzspannung erreicht oder unterschritten haben, wird ein Fehler ausgelöst und/oder eine Fehlermeldung ausgegeben wird. Demnach ist davon auszugehen, dass die Rückspeiseschutzeinrichtung 30 einen Defekt aufweist, z.B. die Schutzschaltung 44 durchgebrannt ist. In dem Fall sollte ein Werker den Fehler quittieren und entsprechende Maßnahmen ergreifen.

## Patentansprüche

1. Endeffektor zur Anordnung an einer Handhabungsvorrichtung, der Endeffektor umfassend:
- wenigstens ein mittels eines elektrischen Antriebs bewegliches Effektorelement,
- eine im Endeffektor integrierte Rückspeiseschutzeinrichtung zur Aufnahme und/oder Umwandlung einer Rückspeisespannung beim Bremsvorgang des elektrischen Antriebs, und
- eine Steuerungseinrichtung zur Steuerung der Rückspeiseschutzeinrichtung, welche dazu gerichtet ist, die Rückspeiseschutzeinrichtung in Abhängigkeit eines Mittelwerts einer Ist-Spannung und einer Aktivierungs-Grenzspannung und/oder Deaktivierungs-Grenzspannung zu steuern, wobei sich die Aktivierungs-Grenzspannung und/oder die Deaktivierungs-Grenzspannung aus der Ist-Spannung und einem Aktivierungs-Offset und/oder einem Deaktivierungs-Offset bestimmt.

2. Endeffektor nach Anspruch 1, wobei die Rückspeiseschutzeinrichtung wenigstens einen Lastwiderstand zum Umwandeln einer Rückspeisespannung in Wärme aufweist.

3. Endeffektor nach Anspruch 1 oder 2, wobei die Rückspeiseschutzeinrichtung einen Schalter zum Aktivieren und Deaktivieren der Rückspeiseschutzeinrichtung aufweist.

4. Endeffektor nach einem der vorherigen Ansprüche,
wobei der Endeffektor eine elektrische Schnittstelle zum Anschluss an eine elektrische Energiequelle zur Energieversorgung des elektrischen Antriebs aufweist, und
wobei die Rückspeiseschutzeinrichtung an einer die elektrische Schnittstelle und den elektrischen Antrieb elektrisch verbindende Versorgungsleitung anschließt.

5. Endeffektor nach den Ansprüchen 2 bis 4, wobei die Rückspeiseschutzeinrichtung derart ausgebildet ist, dass der Schalter in einem Aktivierungszustand den wenigstens einen Lastwiderstand elektrisch mit der Versorgungsleitung verbindet und/oder in einem Deaktivierungszustand den wenigstens einen Lastwiderstand elektrisch von der Versorgungsleitung trennt.

6. Endeffektor nach einem der Ansprüche 4 oder 5, wobei der Endeffektor eine Spannungsmesseinrichtung zum Erfassen einer ersten Größe, die eine an der Versorgungsleitung anliegenden Ist-Spannung charakterisiert, aufweist.

7. Endeffektor nach einem der vorherigen Ansprüche, wobei die Rückspeiseschutzeinrichtung, insbesondere der wenigstens eine Lastwiderstand und/oder der Schalter, auf einer ersten Platine angeordnet ist.

8. Endeffektor nach einem der vorherigen Ansprüche, wobei die Steuerungseinrichtung zur Steuerung des elektrischen Antriebs und zum Aktivieren und Deaktivieren der Rückspeiseschutzeinrichtung eingerichtet ist.

9. Endeffektor nach einem der vorherigen Ansprüche, wobei die Steuerungseinrichtung auf einer zweiten Platine angeordnet ist.

10. Endeffektor nach einem der Ansprüche 4 bis 9, wobei die Steuerungseinrichtung derart eingerichtet ist, dass diese die Rückspeiseschutzeinrichtung in Abhängigkeit einer an der Versorgungsleitung anliegenden Ist-Spannung und/oder eines Betriebszustands des Endeffektors, insbesondere eines motorischen Betriebszustands und eines generatorischen Betriebszustands, aktiviert oder deaktiviert.

11. Endeffektor nach dem vorherigen Anspruch, wobei die Steuerungseinrichtung derart eingerichtet ist,
dass diese die Rückspeiseschutzeinrichtung aktiviert, wenn eine an der Versorgungsleitung anliegende Ist-Spannung eine Aktivierungs-Grenzspannung übersteigt und insbesondere wenn sich der Endeffektor in einem generatorischen Betriebszustand befindet, und/oder
dass diese die Rückspeiseschutzeinrichtung deaktiviert, wenn eine an der Versorgungsleitung anliegende Ist-Spannung eine Deaktivierungs-Grenzspannung unterschreitet und insbesondere wenn sich der Endeffektor in einem motorischen Betriebszustand befindet.

12. Endeffektor nach einem der vorherigen Ansprüche, wobei die Rückspeiseschutzeinrichtung eine temperaturabhängige Schutzschaltung aufweist, welche derart ausgebildet ist, dass diese in einen Unterbrechungszustand wechseln kann.

13. Verfahren zum Betreiben eines Endeffektors, umfassend die folgenden Schritte:
a) Erfassen einer an einer Versorgungsleitung des Endeffektors anliegenden Ist-Spannung,
b) wenn die Ist-Spannung eine Aktivierungs-Grenzspannung überschreitet, Aktivieren einer im Endeffektor integrierten Rückspeiseschutzeinrichtung, wobei sich die Aktivierungs-Grenzspannung aus der Ist-Spannung und einem Aktivierungs-Offset bestimmt, und/oder
c) wenn die Ist-Spannung eine Deaktivierungs-Grenzspannung unterschreitet, Deaktivieren der im Endeffektor integrierten Rückspeiseschutzeinrichtung.

14. Verfahren nach dem vorherigen Anspruch, wobei das Verfahren vor Schritt b) den folgenden Schritt umfasst:
a1) Erfassen eines Betriebszustands des Endeffektors, insbesondere eines generatorischen Betriebszustands oder eines motorischen Betriebszustands.

15. Verfahren nach Anspruch 13 oder 14, wobei die Rückspeiseschutzeinrichtung gemäß Schritt b) nur dann aktiviert wird, wenn die Ist-Spannung die Aktivierungs-Grenzspannung überschreitet und, wenn sich der Endeffektor in einem generatorischen Betriebszustand befindet.

16. Verfahren nach einem der Ansprüche 13 bis 15, wobei die Rückspeiseschutzeinrichtung gemäß Schritt c) nur dann deaktiviert wird, wenn die Ist-Spannung eine Deaktivierungs-Grenzspannung unterschreitet, und/oder, wenn sich der Endeffektor in einem motorischen Betriebszustand befindet.

17. Verfahren nach einem der Ansprüche 13 bis 16, wobei die erfasste Ist-Spannung zur Bestimmung eines Mittelwerts der Ist-Spannung, insbesondere mittels eines Infinite Impulse Response Filter, gefiltert wird.

18. Verfahren nach dem vorherigen Anspruch 17, wobei die Aktivierungs-Grenzspannung mittels Addierens eines Aktivierungs-Offsets zum Mittelwert bestimmt wird.

19. Verfahren nach Anspruch 17 oder 18, wobei die Deaktivierungs-Grenzspannung mittels Addierens eines Deaktivierungs-Offsets zum Mittelwert bestimmt wird.

20. Verfahren nach einem der Ansprüche 13 bis 19, wobei ein Fehler ausgelöst und/oder eine Fehlermeldung ausgegeben wird, wenn bei aktivierter Rückspeiseschutzeinrichtung nach einer maximalen Aktivzeit die Ist-Spannung nicht die Deaktivierungs-Grenzspannung unterschreitet.

21. Computerprogramm, umfassend Befehle, die bei der Ausführung des Computerprogramms durch einen Computer diesen veranlassen, das Verfahren nach einem der Ansprüche 13 bis 20 auszuführen, wobei das Computerprogramm insbesondere eine auf einem Microcontroller ausführbare Firmware umfasst.
